# EUROPEAN PATENT APPLICATION

(11) **EP 4 723 816 A1**
(43) Date of publication of application: **08.04.2026**
(21) Application number: 25797179.6
(22) Date of filing: 24.03.2025
(51) Int. Cl.: H05K 7/14, H05K 7/20, H04Q 1/02

(54) **SERVER CABINET AND COMPLETE CABINET SYSTEM**

(30) Priority: 29.04.2024 CN 202410532727
(71) Applicant: Suzhou Metabrain Intelligent Technology Co., Ltd., Suzhou, Jiangsu 215000 (CN)
(72) Inventor: WANG, An, Suzhou, Jiangsu 215000 (CN); DONG, Chao, Suzhou, Jiangsu 215000 (CN); LIU, Shengjin, Suzhou, Jiangsu 215000 (CN)
(74) Representative: Michalski Hüttermann & Partner Patentanwälte mbB
(86) International application number: PCT/CN2025/084513
(87) International publication number: WO 2025/228003

(57) **Abstract**

The present application discloses a server cabinet and a complete-cabinet system, which relates to the field of server cabinets. The server cabinet includes a cabinet body, a power bus bar and a manifold. The cabinet body has a first direction, both of the power bus bar and the manifold are provided in the cabinet body, a crossbeam is provided in the cabinet body, the cabinet body has two side walls that face each other in the first direction, the two ends of the crossbeam are fixedly connected to the two side walls, and both of the power bus bar and the manifold are fixed to the crossbeam.

## Description

### CROSS-REFERENCE TO RELATED APPLICATION

The present application claims the priority of the Chinese patent application filed on April 29th, 2024 before the Chinese Patent Office with the application number of 202410532727.8 and the title of "SERVER CABINET AND COMPLETE CABINET SYSTEM", which is incorporated herein in its entirety by reference.

### FIELD

The present application relates to the field of server cabinets, and particularly relates to a server cabinet and a complete-cabinet system.

### BACKGROUND

With the development of science and technology, servers are being applied increasingly more extensively. Usually, a server is placed in a server cabinet, an exchange is provided in the server cabinet, and the exchange and the server are connected, whereby the server can transmit data. In the related art, after the server has been placed in the server cabinet, usually it is required to connect the server to a manifold in the server cabinet in an artificial mode; in other words, the operator manually connects the server and the manifold by using a quick connector, whereby the manifold performs cooling and heat dissipation to the server. However, the manual mode results in a low efficiency of the installation, and cannot realize blind-mate insertion of the server.

### SUMMARY

An object of the embodiments of the present application is to provide a server cabinet and a complete-cabinet system, to at least solve the problem that the manual mode results in a low efficiency of the installation, and cannot realize blind-mate insertion of the server.

In the first aspect, an embodiment of the present application provides a server cabinet, wherein the server cabinet comprises a cabinet body, a power bus bar and a manifold; and
the cabinet body has a first direction, both of the power bus bar and the manifold are provided in the cabinet body, a crossbeam is provided in the cabinet body, the cabinet body has two side walls that face each other in the first direction, two ends of the crossbeam are fixedly connected to the two side walls, and both of the power bus bar and the manifold are fixed to the crossbeam, to enable a server to be inserted perpendicularly and in a blind-mate manner to the power bus bar and the manifold.

In some embodiments of the present application, the crossbeam comprises a first mounting member, a connecting beam and a second mounting member;
the first mounting member and the second mounting member are detachably connected to two opposite ends of the connecting beam, the first mounting member is connected to one of the side walls in the first direction of the cabinet body, and the second mounting member is connected to the other of the side walls in the first direction of the cabinet body; and
both of the power bus bar and the manifold are fixed to the connecting beam.

In some embodiments of the present application, a plurality of mounting holes are provided separately in the connecting beam in the first direction, and the power bus bar and the manifold are connected to different instances of the mounting holes.

In some embodiments of the present application, each of the power bus bar and the manifold is closer than the other to one of the two side walls that face each other in the first direction of the cabinet body.

In some embodiments of the present application, the crossbeam further comprises a first connector, the first connector is detachably connected to the mounting holes, and the power bus bar is connected to the first connector, to enable the server to be inserted perpendicularly and in a blind-mate manner to the power bus bar.

In some embodiments of the present application, the crossbeam further comprises a second connector, the second connector is detachably connected to the mounting holes, and the manifold is connected to the second connector, to enable the server to be inserted perpendicularly and in a blind-mate manner to the manifold.

In some embodiments of the present application, the connecting beam is provided with at least one through hole; and
after the server has been installed into the cabinet body, the through hole faces the server, and the through hole ventilates for the server.

In some embodiments of the present application, the cabinet body further has a second direction intersecting with the first direction, the cabinet body has a top and a bottom that face each other in the second direction, and two opposite ends of the power bus bar are connected to the top and the bottom of the cabinet body.

In some embodiments of the present application, the cabinet body has a front opening and a rear opening that face each other, a first hinge is provided at a side wall at the front opening, and the first hinge is connected to a front door;
in response to the front door being in a closing state, the front door blocks the front opening, and the front door is flush with an outer surface of the cabinet body; and
in response to the front door being in an opening state, the front door releases the blocking to the front opening, and the front door has a first included angle with the side walls of the cabinet body.

In some embodiments of the present application, a second hinge is provided at a side wall at the rear opening, and the second hinge is connected to a rear door;
in response to the rear door being in a closing state, the rear door blocks the rear opening, and the rear door is flush with the outer surface of the cabinet body; and
in response to the rear door being in an opening state, the rear door releases the blocking to the rear opening, and the rear door has a second included angle with the side walls of the cabinet body.

In some embodiments of the present application, both of the front door and the rear door are provided with a ventilation hole.

In some embodiments of the present application, the manifold comprises a water inlet pipe, a water outlet pipe and a connecting joint; and
the water inlet pipe and the water outlet pipe are arranged side by side, the water inlet pipe and/or the water outlet pipe are/is connected to the connecting joint, the water inlet pipe is for cooling water to flow in, the water outlet pipe is for cooling water to flow out, and the connecting joint is for connecting the server and/or an exchange.

In some embodiments of the present application, the manifold is provided with a leaked-liquid collecting component, the leaked-liquid collecting component comprises a liquid discharging pipe, the liquid discharging pipe is connected to the water inlet pipe or the water outlet pipe, a collecting member is provided at the liquid discharging pipe, the collecting member is in communication with the liquid discharging pipe, the collecting member is located on a same one side as the connecting joint, the collecting member is for, when the connecting joint is connected to the server and/or the exchange, collecting liquid dripped from the server and/or the exchange, and directing the liquid into the liquid discharging pipe, and the liquid discharging pipe is for discharging the liquid.

In some embodiments of the present application, a collecting disk and a guiding pipe are provided at a bottom of the cabinet body; and
the liquid discharging pipe has a liquid outlet opening, the liquid outlet opening faces the collecting disk, one end of the guiding pipe is in communication with the collecting disk, and the other end of the guiding pipe is located outside the cabinet body.

In some embodiments of the present application, the connecting joint is connected to the water outlet pipe and/or the water inlet pipe by a first elastic member.

In some embodiments of the present application, the power bus bar is provided with an electric-power supplying connector, the electric-power supplying connector is connected to the power bus bar by a second elastic member, and the electric-power supplying connector is for being connected to the server and/or an exchange, to supply electric power to the server and/or the exchange.

In some embodiments of the present application, each of the two side walls in the first direction of the cabinet body is connected to an adapter bracket, the adapter brackets are located in the cabinet body, the adapter brackets are for installing a server of a first size, and the side walls of the cabinet body are for installing a server of a second size;
wherein the size of the server of the first size and the size of the server of the second size are unequal.

In some embodiments of the present application, the cabinet body has a front opening and a rear opening, each of the adapter brackets is connected to a first sliding rail, the first sliding rails extend in a direction from the front opening to the rear opening, and the first sliding rails are for installing the server of the first size; and
each of the side walls of the cabinet body is provided with a second sliding rail, the second sliding rails extend in the direction from the front opening to the rear opening, and the second sliding rails are for installing the server of the second size.

In some embodiments of the present application, fixing strips are provided at both of the front opening and the rear opening of the cabinet body, fixing holes are provided separately in each of the fixing strips, the fixing strips extend in a direction from a top of the cabinet body to a bottom of the cabinet body, and the fixing holes are for fixing the server of the first size and/or the server of the second size.

In some embodiments of the present application, the cabinet body has a front opening and a rear opening, each of the two side walls that face each other in the first direction of the cabinet body is connected to a third sliding rail, and the third sliding rails are for installing an exchange.

In some embodiments of the present application, the cabinet body has a front opening and a rear opening, each of the two side walls that face each other in the first direction of the cabinet body is connected to a fourth sliding rail, and the fourth sliding rails are for installing a power-supply frame.

In the second aspect, an embodiment of the present application provides a complete-cabinet system, wherein the complete-cabinet system comprises a server and the server cabinet according to any one of the above embodiments in the first aspect; and
the server is installed in the cabinet body, and the server is connected to the power bus bar and the manifold.

In some embodiments of the present application, a third sliding rail and a fourth sliding rail are provided in the cabinet body, the complete-cabinet system further comprises an exchange and a power-supply frame, and an electric-power supplying device is provided in the power-supply frame; and

the exchange is installed in the cabinet body via the third sliding rail, and the power-supply frame is installed in the cabinet body via the fourth sliding rail.

In the embodiments of the present application, because both of the power bus bar and the manifold are provided in the cabinet body, the crossbeam is provided in the cabinet body, the cabinet body has two side walls that face each other in the first direction, the two ends of the crossbeam are fixedly connected to the two side walls, and both of the power bus bar and the manifold are fixed to the crossbeam, when the server is being installed into the cabinet body, one may apply force directly to the server, so that, once the server has entered the cabinet body, the server can be connected to the power bus bar and the manifold simultaneously, to realize blind-mate insertion of the server. Furthermore, the power bus bar and the manifold are fixed to the crossbeam, whereby, when one is applying force to the server, to cause the server to be installed into the cabinet body, the server can apply force to the power bus bar and the manifold, and the power bus bar and the manifold can transfer the force to the crossbeam, which means that the crossbeam can serve to support the power bus bar and the manifold. In other words, in the embodiments of the present application, by providing the crossbeam in the cabinet body and configuring that both of the manifold and the power bus bar are fixed to the crossbeam, in the installation of the server into the cabinet body, the server can be directly pushed into the cabinet body, so that the server can be connected to the power bus bar and the manifold simultaneously. That prevents the problem that, in the installation of the server, the operator manually connects the server and the manifold, which results in a low efficiency of the installation. In other words, the server cabinet according to the embodiments of the present application may increase the efficiency of the installation of the server into the cabinet body, and may realize blind-mate insertion of the server.

### BRIEF DESCRIPTION OF THE DRAWINGS

FIG. 1 illustrates an axonometric drawing of a server cabinet according to an embodiment of the present application;
FIG. 2 illustrates a first schematic diagram of a fixing strip according to an embodiment of the present application;
FIG. 3 illustrates a partially enlarged view of the position M in FIG. 2;
FIG. 4 illustrates a rear view of a server cabinet according to an embodiment of the present application;
FIG. 5 illustrates a partially enlarged view of the position A in FIG. 4;
FIG. 6 illustrates a partially enlarged view of the position B in FIG. 4;
FIG. 7 illustrates a schematic diagram of a front door connected to a cabinet body according to an embodiment of the present application;
FIG. 8 illustrates a first schematic diagram of a manifold according to an embodiment of the present application;
FIG. 9 illustrates a partially enlarged view of the position C in FIG. 8;
FIG. 10 illustrates a second schematic diagram of a manifold according to an embodiment of the present application;
FIG. 11 illustrates a schematic diagram of a power-supply frame according to an embodiment of the present application;
FIG. 12 illustrates a second schematic diagram of a fixing strip according to an embodiment of the present application;
FIG. 13 illustrates a schematic diagram of a second sliding rail according to an embodiment of the present application;
FIG. 14 illustrates a schematic diagram of a power bus bar according to an embodiment of the present application;
FIG. 15 illustrates a schematic diagram of a first sliding rail according to an embodiment of the present application;
FIG. 16 illustrates an exploded view of a crossbeam according to an embodiment of the present application;
FIG. 17 illustrates a first exploded view of a server cabinet according to an embodiment of the present application;
FIG. 18 illustrates a second exploded view of a server cabinet according to an embodiment of the present application; and
FIG. 19 illustrates an exploded view of a complete-cabinet system according to an embodiment of the present application.

### Reference numbers:

001: collecting disk; 002: guiding pipe; 10: cabinet body; 101: side walls; 11: second sliding rail; 12: fixing strip; 13: third sliding rail; 14: fourth sliding rail; 121: fixing holes; 20: power bus bar; 30: manifold; 31: water inlet pipe; 32: water outlet pipe; 33: connecting joint; 34: leaked-liquid collecting component; 341: liquid discharging pipe; 342: collecting member; 40: crossbeam; 41: first mounting member; 42: connecting beam; 43: second mounting member; 44: first connector; 45: second connector; 421: mounting holes; 422: through hole; 100: front door; 200: rear door; 300: server; 400: exchange; 500: power-supply frame; and 600: cooling-liquid distributing device.

### DETAILED DESCRIPTION

The features defined by the terms "first" and "second" in the description and the claims of the present application may explicitly or implicitly comprise one or more of the features. In the description of the present application, unless stated otherwise, the meaning of "plurality of" is "two or more". Furthermore, the "and/or" in the description and the claims indicates at least one of the linked objects, and the character "/" generally indicates that the linked objects are of the relation of "or".

In the description of the present application, it should be understood that the terms that indicate orientation or position relations, such as "central", "longitudinal", "transverse", "length", "width", "thickness", "upper", "lower", "front", "rear", "left", "right", "vertical", "horizontal", "top", "bottom", "inner", "outer", "clockwise", "anticlockwise", "axial", "radial" and "circumferential", are based on the orientation or position relations shown in the drawings, and are merely for conveniently describing the present application and simplifying the description, rather than indicating or implying that the device or element must have the specific orientation and be constructed and operated according to the specific orientation. Therefore, they should not be construed as a limitation on the present application.

In the description of the present application, it should be noted that, unless explicitly defined or limited otherwise, the terms "mount", "connect" and "link" should be interpreted broadly. For example, it may be fixed connection, detachable connection, or integral connection; it may be mechanical connection or electrical connection; and it may be direct connection or indirect connection by an intermediate medium, and may be the internal communication between two elements. For a person skilled in the art, the particular meanings of the above terms in the present application may be comprehended according to particular situations.

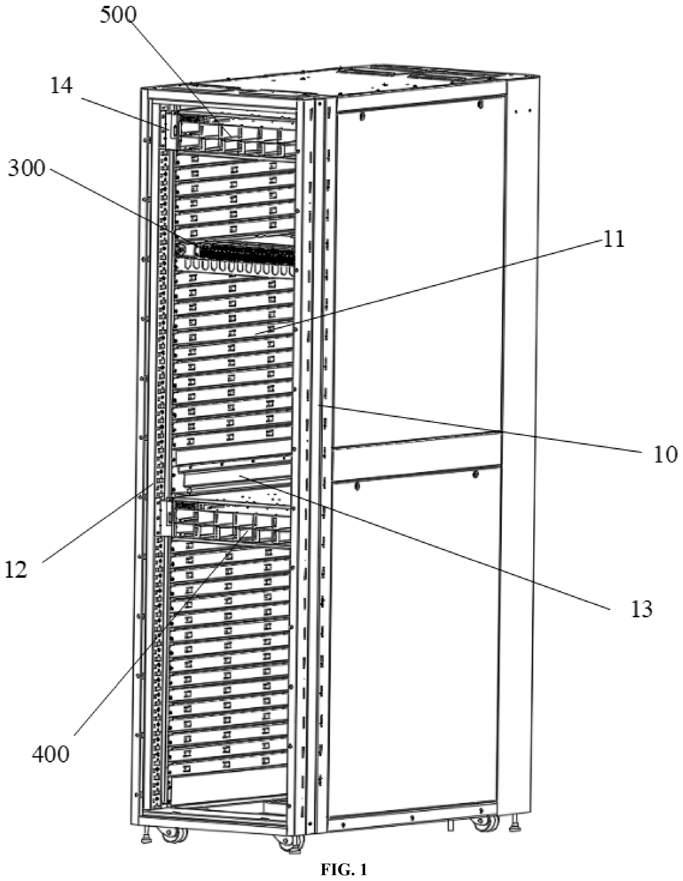

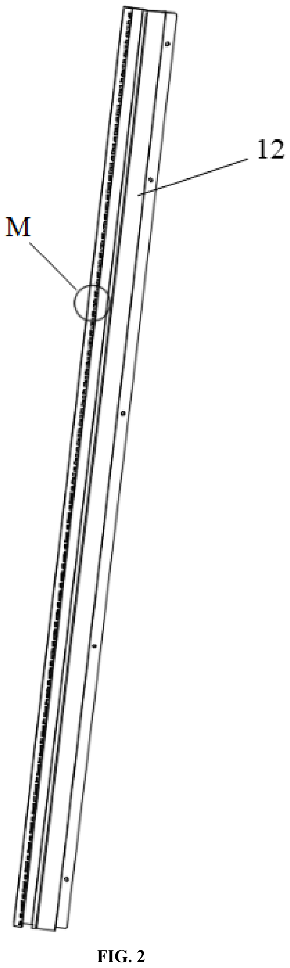

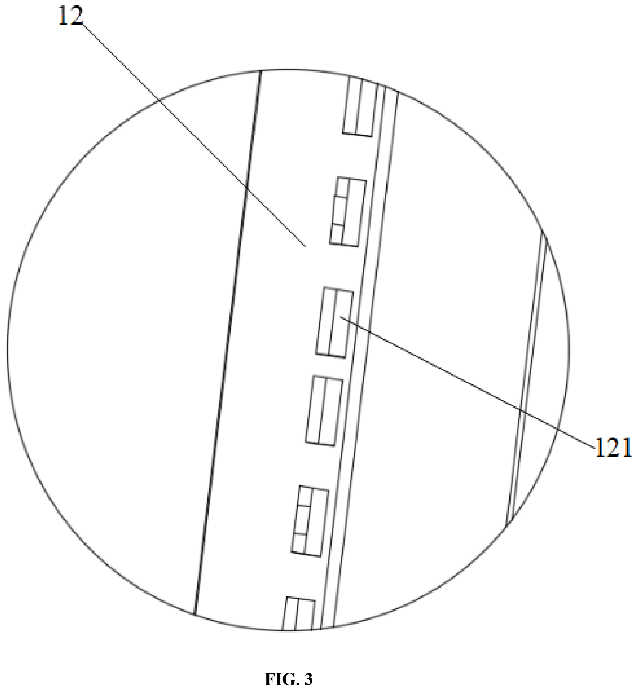

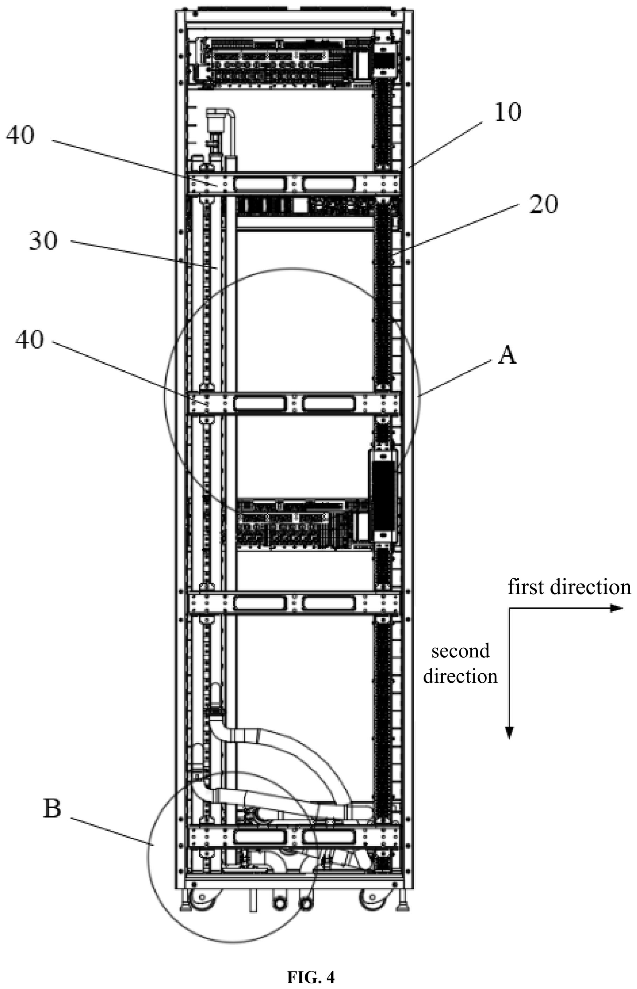

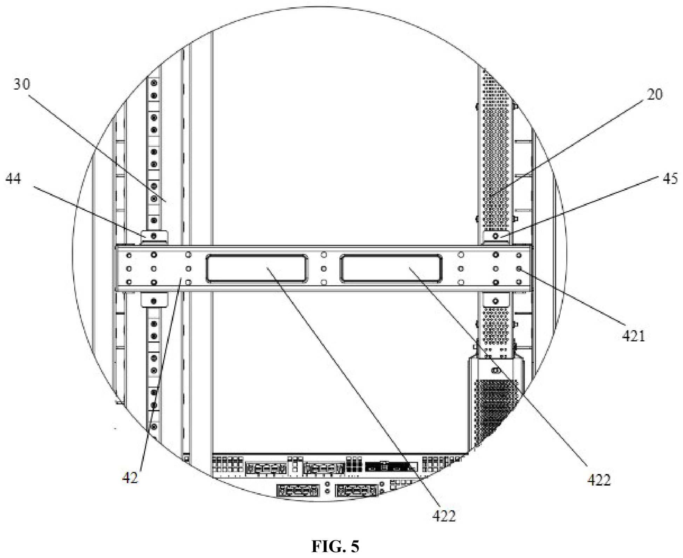

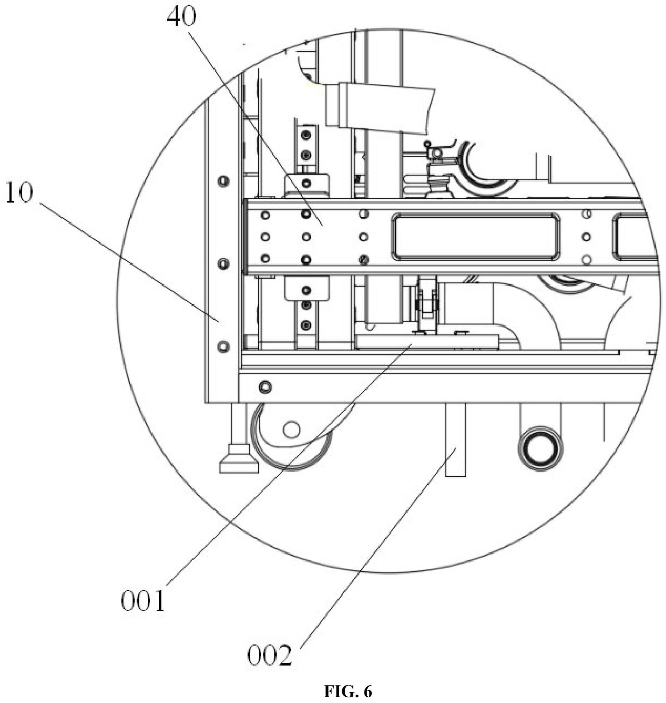

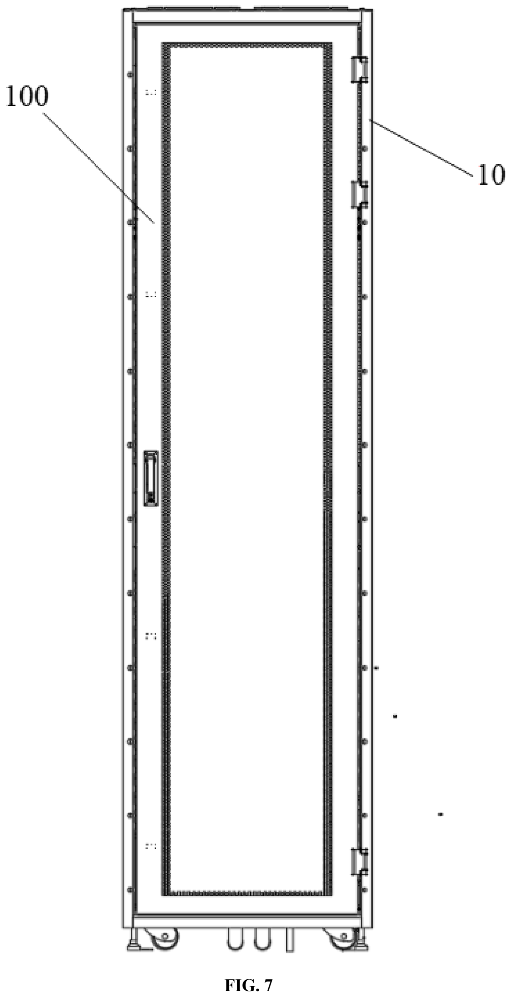

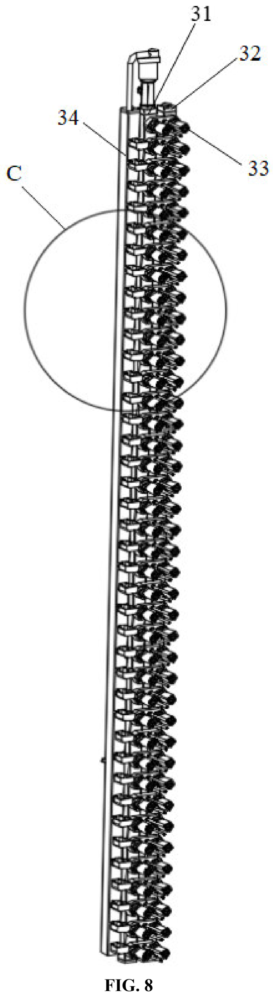

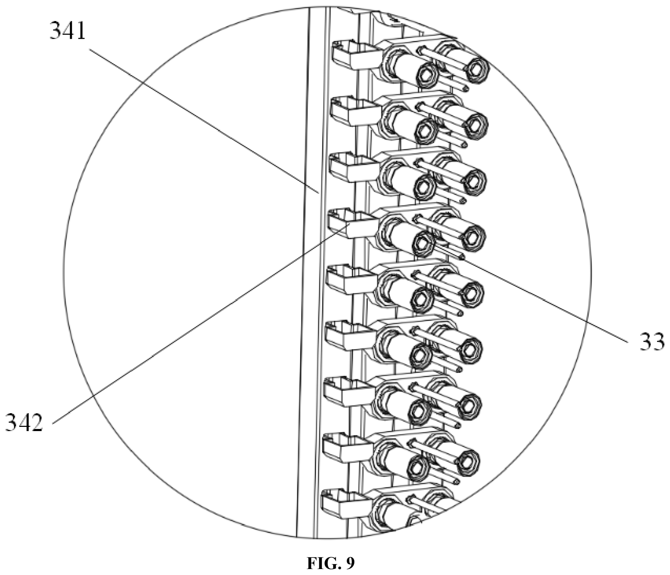

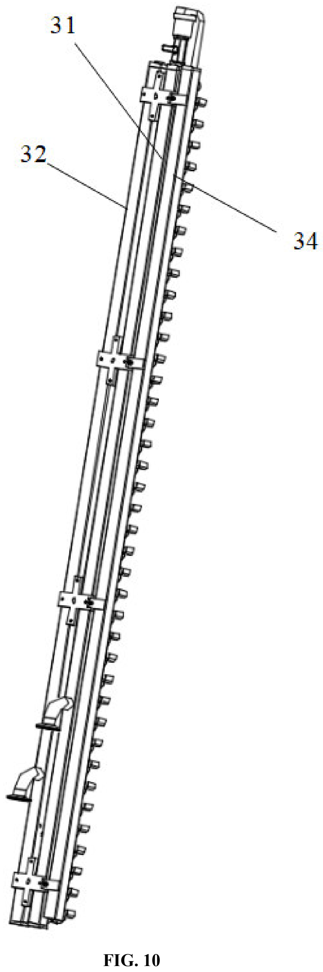

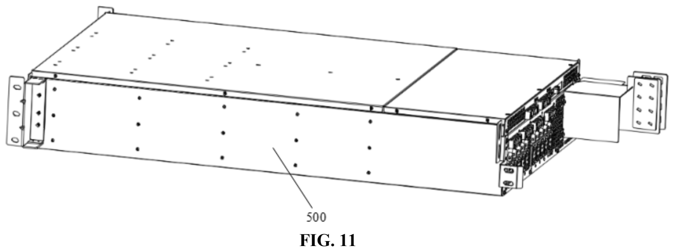

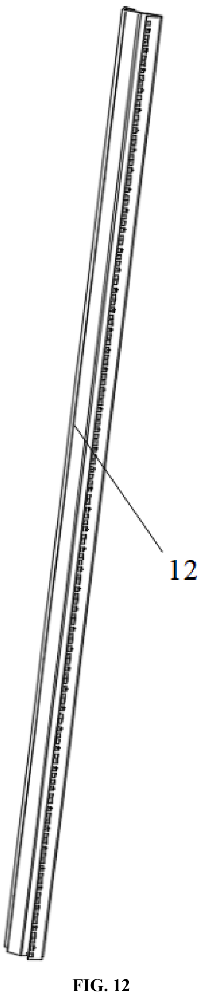

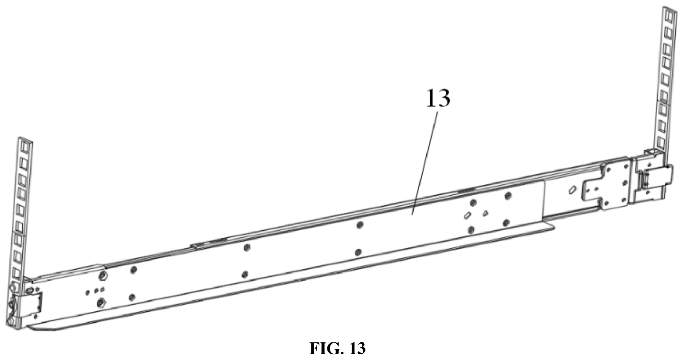

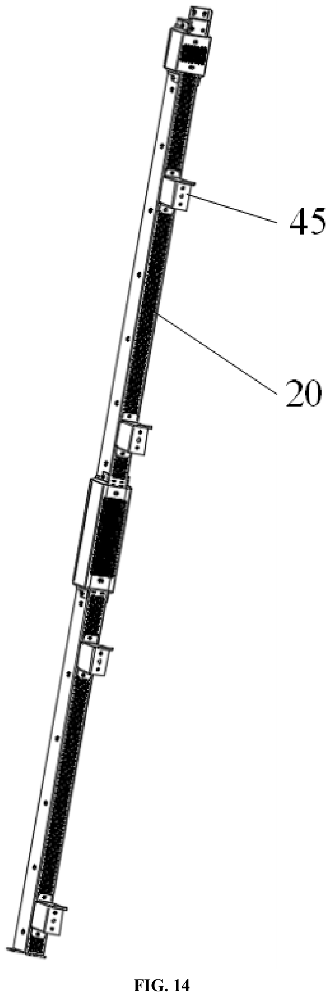

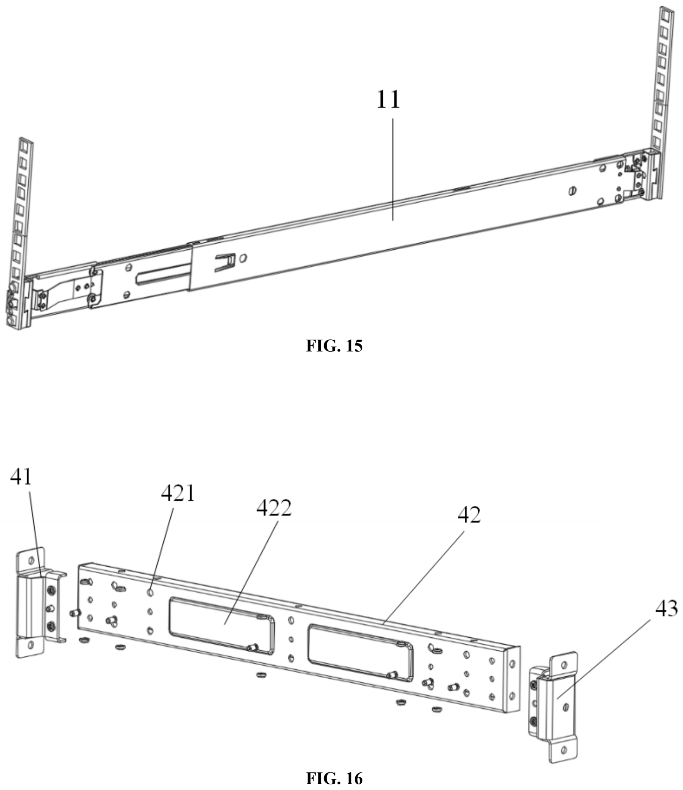

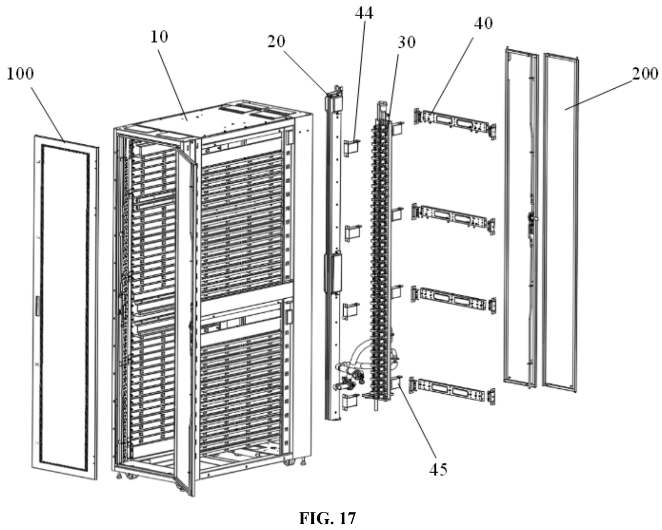

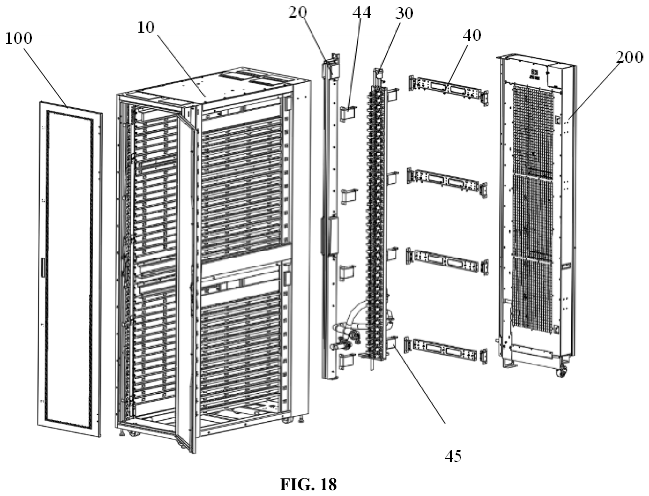

As shown in FIGS. 1 to 19, the server cabinet comprises a cabinet body 10, a power bus bar 20 and a manifold 30.

The cabinet body 10 has a first direction, both of the power bus bar 20 and the manifold 30 are provided in the cabinet body 10, a crossbeam 40 is provided in the cabinet body 10, the cabinet body 10 has two side walls 101 that face each other in the first direction, the two ends of the crossbeam 40 are fixedly connected to the two side walls 101, and both of the power bus bar 20 and the manifold 30 are fixed to the crossbeam 40, to enable a server 300 to be inserted perpendicularly and in a blind-mate manner to the power bus bar 20 and the manifold 30.

In the embodiments of the present application, because both of the power bus bar 20 and the manifold 30 are provided in the cabinet body 10, the crossbeam 40 is provided in the cabinet body 10, the cabinet body 10 has two side walls 101 that face each other in the first direction, the two ends of the crossbeam 40 are fixedly connected to the two side walls 101, and both of the power bus bar 20 and the manifold 30 are fixed to the crossbeam 40, when the server 300 is being installed into the cabinet body 10, one may apply force directly to the server 300, so that, once the server 300 has entered the cabinet body 10, the server 300 can be connected to the power bus bar 20 and the manifold 30 simultaneously, to realize blind-mate insertion of the server 300. Furthermore, the power bus bar 20 and the manifold 30 are fixed to the crossbeam 40, whereby, when one is applying force to the server 300, to cause the server 300 to be installed into the cabinet body 10, the server 300 can apply force to the power bus bar 20 and the manifold 30, and the power bus bar 20 and the manifold 30 can transfer the force to the crossbeam 40, which means that the crossbeam 40 can serve to support the power bus bar 20 and the manifold 30. In other words, in the embodiments of the present application, by providing the crossbeam 40 in the cabinet body 10 and configuring that both of the manifold 30 and the power bus bar 20 are fixed to the crossbeam 40, in the installation of the server 300 into the cabinet body 10, the server 300 can be directly pushed into the cabinet body 10, so that the server 300 can be connected to the power bus bar and the manifold 30 simultaneously. That prevents the problem that, in the installation of the server 300, the operator manually connects the server 300 and the manifold 30, which results in a low efficiency of the installation. In other words, the server cabinet according to the embodiments of the present application may increase the efficiency of the installation of the server 300 into the cabinet body 10, and may realize blind-mate insertion of the server 300.

It should be noted that both of the power bus bar 20 and the manifold 30 may be provided with a connector. After the server 300 has been installed into the cabinet body 10, the connector of the power bus bar 20 and the connector of the manifold 30 can be directly connected to the server 300, thereby preventing manual connection by the operator, to realize blind-mate insertion of the server 300. In the installation of the server 300 in the cabinet body 10, after the server 300 has entered the cabinet body 10, the rear end of the server 300 can be plug-connected to the power bus bar 20 and the manifold 30 in the direction perpendicular to the crossbeam, which can realize blind-mate insertion, which means that the server 300 is connected simultaneously to the manifold 30 and the power bus bar 20, to enable the server 300 to be supplied electric power and be cooled.

In addition, in an embodiment of the present application, the crossbeam 40 may be a plurality of crossbeams 40, the cabinet body 10 has a second direction intersecting with the first direction, and the plurality of crossbeams 40 may be arranged separately in the second direction. The first direction may be the horizontal direction, the second direction may be the vertical direction, and the first direction and the second direction may be perpendicular.

In addition, when the first direction is the horizontal direction, the crossbeam 40 extends in the first direction, the distance between the two side walls 101 that face each other in the first direction of the cabinet body 10 is equivalent to the width of the cabinet body 10, and the crossbeam 40 is provided in the cabinet body 10 in the width direction. When the crossbeam 40 is a plurality of crossbeams 40, the plurality of crossbeams 40 can support the cabinet body 10 in the width direction of the cabinet body 10, to prevent the problem that the cabinet body 10 easily deforms.

In addition, in some embodiments, the crossbeam 40 may comprise a first mounting member 41, a connecting beam 42 and a second mounting member 43. The first mounting member 41 and the second mounting member 43 are detachably connected to the two opposite ends of the connecting beam 42, the first mounting member 41 is connected to one of the side walls 101 in the first direction of the cabinet body 10, and the second mounting member 43 is connected to the other of the side walls 101 in the first direction of the cabinet body 10. Both of the power bus bar 20 and the manifold 30 are fixed to the connecting beam 42.

Because the first mounting member 41 and the second mounting member 43 are detachably connected to the two opposite ends of the connecting beam 42, when the crossbeam 40 is being mounted into the cabinet body 10, the process may comprise firstly mounting the first mounting member 41 to one side wall 101 in the first direction of the cabinet body 10, mounting the second mounting member 43 to the other side wall 101 in the first direction of the cabinet body 10, and subsequently connecting the two ends of the connecting beam 42 to the first mounting member 41 and the second mounting member 43, which may facilitate the mounting of the crossbeam 40 in the cabinet body 10. In addition, both of the power bus bar 20 and the manifold 30 are fixed to the connecting beam 42, so that the connecting beam 42 can serve to support the power bus bar 20 and the manifold 30.

It should be noted that, in order to enable the crossbeam 40 to serve to support the cabinet body 10 better, the length of the crossbeam 40 is usually greater than or equal to the width of the cabinet body 10. However, with such a configuration, when the crossbeam 40 is being mounted into the cabinet body 10, it is required to incline the crossbeam 40 before it can enter the cabinet body 10, and the crossbeam 40 is difficult to mount. In the embodiments of the present application, by configuring that the crossbeam 40 comprises the first mounting member 41, the connecting beam 42 and the second mounting member 43, the first mounting member 41 and the second mounting member 43 can be firstly mounted, and the connecting beam 42 can be subsequently mounted, whereby the crossbeam 40 may be mounted into the cabinet body 10 more easily.

In addition, in an embodiment of the present application, the mode in which the first mounting member 41 and the second mounting member 43 are detachably connected to the two ends of the connecting beam 42 may be that the connecting beam 42 may be provided with connecting holes at the two ends, the first mounting member 41 and the second mounting member 43 also may be provided with connecting holes, a bolt penetrates the connecting hole in the first mounting member 41 and the connecting hole in one end of the connecting beam 42, to cause the first mounting member 41 to be connected to the one end of the connecting beam 42, and a bolt penetrates the connecting hole in the second mounting member 43 and the connecting hole in the other end of the connecting beam 42, to cause the second mounting member 43 to be connected to the other end of the connecting beam 42. Certainly, the mode in which the first mounting member 41 and the second mounting member 43 are detachably connected to the two ends of the connecting beam 42 may also be another mode. For example, both of the first mounting member 41 and the second mounting member 43 are provided with a snap-fitting hole, the two ends of the connecting beam 42 are provided with snap-fitting bosses, and the snap-fitting bosses at the two ends of the connecting beam 42 are embedded in the snap-fitting hole in the first mounting member 41 and the snap-fitting hole in the second mounting member 43, to realize the connection of the two ends of the connecting beam 42 to the first mounting member 41 and the second mounting member 43. That is not limited in the embodiments of the present application.

In addition, in an embodiment of the present application, both of the first mounting member 41 and the second mounting member 43 may be fixed to the two side walls 101 that face each other of the cabinet body 10 by using fastening screws.

In addition, in some embodiments, a plurality of mounting holes 421 may be provided separately in the connecting beam 42 in the first direction, and the power bus bar 20 and the manifold 30 are connected to different mounting holes 421.

Because the plurality of mounting holes 421 are provided separately in the connecting beam 42 in the first direction, when the power bus bar 20 and the manifold 30 are being connected to the connecting beam 42, suitable mounting holes 421 can be selected to be connected to the power bus bar 20 and connected to the manifold 30 according to practical demands, so that, after the power bus bar 20 and the manifold 30 have been mounted, they can satisfy the requirements by the servers 300 of unequal sizes. In other words, by providing the plurality of mounting holes 421 separately in the connecting beam 42 in the first direction, the power bus bar 20 and the manifold 30 can be mounted at different positions of the connecting beam 42 according to practical demands, so as to satisfy the requirements by the servers 300 of unequal sizes, thereby facilitating to provide the servers 300 of unequal sizes in the cabinet body 10.

It should be noted that the mounting holes 421 may be threaded holes. Certainly, the mounting holes 421 may also be unthreaded holes. The particular type of the mounting holes 421 is not limited in the embodiments of the present application.

In addition, the quantity of the mounting holes 421 may be configured according to practical demands. For example, the quantity of the mounting holes 421 is 10. As another example, the quantity of the mounting holes 421 is 8. That is not limited in the embodiments of the present application.

In addition, in some embodiments, each of the power bus bar 20 and the manifold 30 may be closer than the other to one of the two side walls 101 that face each other in the first direction of the cabinet body 10. With such a configuration, the power bus bar 20 and the manifold 30 may have a high distance therebetween, to prevent the problem that the power bus bar 20 and the manifold 30 might affect each other.

In addition, in some embodiments, the crossbeam 40 may further comprise a first connector 44, the first connector 44 is detachably connected to the mounting holes 421, and the power bus bar 20 is connected to the first connector 44.

By providing the first connector 44 and configuring that the first connector 44 is detachably connected to the mounting holes 421, when the power bus bar 20 is being connected to the connecting beam 42, the power bus bar 20 can be directly connected to the first connector 44, which facilitates to connect the power bus bar 20 and the connecting beam 42. Furthermore, by providing the first connector 44, when the server 300 is being placed into the cabinet body 10, the server 300 might apply force to the power bus bar 20, so that the power bus bar 20 can transfer the force to the first connector 44, whereby the first connector 44 supports the power bus bar 20 via the connecting beam 42. In other words, by providing the first connector 44, in an aspect, that may facilitate to connect the power bus bar 20 and the connecting beam 42. In another aspect, the first connector 44 can serve to support the power bus bar 20, so that the power bus bar 20 is more stable.

It should be noted that the first connector 44 may be connected to the mounting holes 421 by bolts. Certainly, the first connector 44 may also be connected to the mounting holes 421 by pins. That is not limited in the embodiments of the present application.

In addition, in an embodiment of the present application, the power bus bar 20 and the first connector 44 may be connected by a bolt. Certainly, they may also be connected by a pin. Certainly, they may also be connected by welding. That is not limited in the embodiments of the present application.

In addition, in some embodiments, the crossbeam 40 may further comprise a second connector 45, the second connector 45 is detachably connected to the mounting holes 421, and the manifold 30 is connected to the second connector 45.

By providing the second connector 45 and configuring that the second connector 45 is detachably connected to the mounting holes 421, when the manifold 30 is being connected to the connecting beam 42, the manifold 30 can be directly connected to the second connector 45, which facilitates to connect the manifold 30 and the connecting beam 42. Furthermore, by providing the second connector 45, when the server 300 is being placed into the cabinet body 10, the server 300 might apply force to the manifold 30, so that the manifold 30 can transfer the force to the second connector 45, whereby the second connector 45 supports the manifold 30 via the connecting beam 42. In other words, by providing the second connector 45, in an aspect, that may facilitate to connect the manifold 30 and the connecting beam 42. In another aspect, the second connector 45 can serve to support the manifold 30, so that the manifold 30 is more stable.

It should be noted that the second connector 45 may be connected to the mounting holes 421 by bolts. Certainly, the second connector 45 may also be connected to the mounting holes 421 by pins. That is not limited in the embodiments of the present application.

In addition, in an embodiment of the present application, the manifold 30 and the second connector 45 may be connected by a bolt. Certainly, they may also be connected by a pin. Certainly, they may also be connected by welding. That is not limited in the embodiments of the present application.

In addition, in an embodiment of the present application, the quantities of the first connector 44 and the second connector 45 may be plural, the sizes of the plurality of first connectors 44 are unequal, and the sizes of the plurality of second connectors 45 are unequal. Therefore, the first connector 44 of the suitable size and the second connector 45 of the suitable size may be selected according to practical demands, so that all of the servers 300 of unequal sizes can be installed in the cabinet body 10. The depths by which the servers 300 of unequal sizes are inserted into the cabinet body 10 are unequal, and therefore the first connectors 44 of unequal sizes and the second connectors 45 of unequal sizes may be selected, to satisfy the requirements by the servers 300 of unequal sizes.

In addition, in some embodiments, the connecting beam 42 may be provided with at least one through hole 422. After the server 300 has been installed into the cabinet body 10, the through hole 422 faces the server 300, and the through hole 422 ventilates for the server 300.

Because the connecting beam 42 is provided with at least one through hole 422, after the server 300 has been installed into the cabinet body 10, the through hole 422 can face the server 300, so that the through hole 422 can ventilate for the server 300, to facilitate the heat dissipation of the server 300. Furthermore, by providing the through hole 422, when the server 300 is being connected to a cable, the cable may be caused to penetrate the through hole 422, which facilitates to connect the server 300 to the cable. If the connecting beam 42 is not provided with the through hole 422, after the server 300 has been installed into the cabinet body 10, the crossbeam 40 might block the server 300, which affects the heat dissipation of the server 300. However, by providing the through hole 422 in the connecting beam 42, after the server 300 has been installed into the cabinet body 10, at the position of the through hole 422, the server 300 is not blocked, so that the through hole 422 can ventilate for the server 300, which facilitates the heat dissipation of the server 300.

It should be noted that the through hole 422 in the connecting beam 42 may extend throughout the connecting beam 42 in the direction from the power bus bar 20 to the connecting beam 42. In addition, the quantity of the through hole 422 may be configured according to practical demands. For example, the quantity of the through hole 422 is 3. As another example, the quantity of the through hole 422 is 4. That is not limited in the embodiments of the present application.

In addition, the shape of the through hole 422 may be configured according to practical demands. For example, the through hole 422 is a circular hole. As another example, the through hole 422 is a square hole. The particular shape of the through hole 422 is not limited in the embodiments of the present application.

In addition, when the connecting beam 42 is provided with the mounting hole 421 and the through hole 422, the size of the through hole 422 is greater than the size of the mounting hole 421.

In addition, in some embodiments, the cabinet body 10 may further have a second direction intersecting with the first direction, the cabinet body 10 has a top and a bottom that face each other in the second direction, and the two opposite ends of the power bus bar 20 are connected to the top and the bottom of the cabinet body 10.

Because the two opposite ends of the power bus bar 20 are connected to the top and the bottom of the cabinet body 10, after the power bus bar 20 has been provided in the cabinet body 10, when the power-supply frame 500 is provided in the cabinet body 10, no matter at what position the power-supply frame 500 is provided in the cabinet body 10, the connection between the power-supply frame 500 and the power bus bar 20 can be realized. In other words, by connecting the two ends of the power bus bar 20 to the top and the bottom of the cabinet body 10, it may be realized that the power-supply frame 500 is mounted at any position in the cabinet body 10, so that the power-supply frame 500 is mounted in the cabinet body 10 within a bigger area.

In addition, in some embodiments, the cabinet body 10 may have a front opening and a rear opening that face each other, a first hinge may be provided at a side wall 101 at the front opening, and the first hinge is connected to a front door 100. When the front door 100 is in a closing state, the front door 100 blocks the front opening, and the front door 100 is flush with the outer surface of the cabinet body 10. When the front door 100 is in an opening state, the front door 100 releases the blocking to the front opening, and the front door 100 has a first included angle with the side walls 101 of the cabinet body 10.

Because the first hinge may be provided at the side wall 101 at the front opening, and the first hinge is connected to the front door 100, the front door 100 can move relative to the side wall 101 of the cabinet body 10 via the first hinge, so that the front door 100 is in different states. Particularly, when the front door 100 is in a closing state, the front door 100 blocks the front opening, and the front door 100 is flush with the outer surface of the cabinet body 10. Therefore, the front door 100 does not protrude out of the cabinet body 10, which means that the front door 100 is embedded in the cabinet body 10. When the front door 100 is in an opening state, the front door 100 releases the blocking to the front opening, and the front door 100 has a first included angle with the side walls 101 of the cabinet body 10. Therefore, the air outside the cabinet body 10 can flow into the cabinet body 10, so that the interior of the cabinet body 10 can be ventilated and heat-dissipated. In addition, by providing the front door 100, the components in the cabinet body 10 such as the server 300 can be protected.

It should be noted that the outer surface of the cabinet body 10 refers to the surface of the side wall 101 of the cabinet body 10.

In addition, in an embodiment of the present application, that the first hinge is provided at the side wall 101 at the front opening means that the first hinge is located in the cabinet body 10. Therefore, after the first hinge has been connected to the front door 100, the front door 100 is mounted at the front opening by embedding, so that, when the front door 100 is opened, the front door 100 occupies a small space. Furthermore, by mounting the front door 100 by embedding, the room inside the cabinet body 10 can be utilized to the largest extent.

In addition, in some embodiments, a second hinge may be provided at a side wall 101 at the rear opening, and the second hinge is connected to a rear door 200. When the rear door 200 is in a closing state, the rear door 200 blocks the rear opening, and the rear door 200 is flush with the outer surface of the cabinet body 10. When the rear door 200 is in an opening state, the rear door 200 releases the blocking to the rear opening, and the rear door 200 has a second included angle with the side walls 101 of the cabinet body 10.

Because the second hinge may be provided at the side wall 101 at the rear opening, and the second hinge is connected to the rear door 200, the rear door 200 can move relative to the side wall 101 of the cabinet body 10 via the second hinge, so that the rear door 200 is in different states. Particularly, when the rear door 200 is in a closing state, the rear door 200 blocks the rear opening, and the rear door 200 is flush with the outer surface of the cabinet body 10. Therefore, the rear door 200 does not protrude out of the cabinet body 10, which means that the rear door 200 is embedded in the cabinet body 10. When the rear door 200 is in an opening state, the rear door 200 releases the blocking to the rear opening, and the rear door 200 has a second included angle with the side walls 101 of the cabinet body 10. Therefore, the air outside the cabinet body 10 can flow into the cabinet body 10, so that the interior of the cabinet body 10 can be ventilated and heat-dissipated. In addition, by providing the rear door 200, the components in the cabinet body 10 such as the server 300 can be protected.

It should be noted that the outer surface of the cabinet body 10 refers to the surface of the side wall 101 of the cabinet body 10.

In addition, in an embodiment of the present application, that the second hinge is provided at the side wall 101 at the rear opening means that the second hinge is located in the cabinet body 10. Therefore, after the second hinge has been connected to the rear door 200, the rear door 200 is mounted at the rear opening by embedding, so that, when the rear door 200 is opened, the rear door 200 occupies a small space. Furthermore, by mounting the rear door 200 by embedding, the room inside the cabinet body 10 can be utilized to the largest extent.

In addition, in an embodiment of the present application, the front door 100 may be a single door, and the rear door 200 may be a double door. Certainly, both of the front door 100 and the rear door 200 may be single doors, and both of the front door 100 and the rear door 200 may be double doors. That is not limited in the embodiments of the present application.

In addition, in an embodiment of the present application, the rear door 200 may be a liquid-cooling door.

In addition, in some embodiments, both of the front door 100 and the rear door 200 are provided with a ventilation hole.

With such a configuration, after the front door 100 and the rear door 200 have been closed, the ventilation holes can cause the cabinet body 10 to be ventilated, which facilitates the heat dissipation of the server 300 in the cabinet body 10. In other words, by providing the ventilation holes in the front door 100 and the rear door 200, that may facilitate the heat dissipation of the components in the cabinet body 10 such as the server 300, to increase the efficiency of the heat dissipation of the interior of the cabinet body 10.

It should be noted that both of the quantity of the ventilation holes in the front door 100 and the quantity of the ventilation holes in the rear door 200 may be configured according to practical demands. For example, the quantity of the ventilation holes in the front door 100 is 100, and the quantity of the ventilation holes in the rear door 200 is 100. As another example, the quantity of the ventilation holes in the front door 100 is 150, and the quantity of the ventilation holes in the rear door 200 is 130. That is not limited in the embodiments of the present application.

In addition, in some embodiments, the manifold 30 may comprise a water inlet pipe 31, a water outlet pipe 32 and a connecting joint 33. The water inlet pipe 31 and the water outlet pipe 32 are arranged side by side, the water inlet pipe 31 and/or the water outlet pipe 32 are/is connected to the connecting joint 33, the water inlet pipe 31 is for cooling water to flow in, the water outlet pipe 32 is for cooling water to flow out, and the connecting joint 33 is for connecting the server 300 and/or an exchange 400.

Because the manifold 30 comprises the water inlet pipe 31, the water outlet pipe 32 and the connecting joint 33, the water inlet pipe 31 and the water outlet pipe 32 are arranged side by side, and the water inlet pipe 31 and/or the water outlet pipe 32 are/is connected to the connecting joint 33, after the server 300 and/or the exchange 400 have/has been placed into the cabinet body 10, the server 300 and/or the exchange 400 may be connected to the connecting joint 33. Subsequently, the cooling water may be injected into the water inlet pipe 31, and the cooling water flows to the water outlet pipe 32. During the flowing of the cooling water, the cooling water absorbs the heat generated by the server 300 and/or the exchange 400, so that the server 300 and/or the exchange 400 are/is heat-dissipated and cooled. In other words, by providing the water inlet pipe 31, the water outlet pipe 32 and the connecting joint 33, that may facilitate the heat dissipation of the server 300 and/or the exchange 400 in the cabinet body 10.

It should be noted that the water inlet pipe 31 may be provided with a water inlet opening, and the water outlet pipe 32 may be provided with a water outlet opening. The cooling water is injected into the water inlet pipe 31 via the water inlet opening, and the water inlet pipe 31 is in communication with the water outlet pipe 32, whereby the cooling water in the water inlet pipe 31 can flow into the water outlet pipe 32, and flow out of the water outlet opening. Therefore, the cooling water can be continuously injected into the water inlet pipe 31, and the cooling water can continuously flow out of the water outlet pipe 32, so as to continuously perform heat dissipation to the server 300 and/or the exchange 400 in the cabinet body 10.

In addition, in some embodiments, the manifold 30 may be provided with a leaked-liquid collecting component 34, the leaked-liquid collecting component 34 comprises a liquid discharging pipe 341, the liquid discharging pipe 341 is connected to the water inlet pipe 31 or the water outlet pipe 32, a collecting member 342 is provided at the liquid discharging pipe 341, the collecting member 342 is in communication with the liquid discharging pipe 341, the collecting member 342 is located on the same one side as the connecting joint 33, the collecting member 342 is for, when the connecting joint 33 is connected to the server 300 and/or the exchange 400, collecting the liquid dripped from the server 300 and/or the exchange 400, and directing the liquid into the liquid discharging pipe 341, and the liquid discharging pipe 341 is for discharging the liquid.

Because the leaked-liquid collecting component 34 comprises the liquid discharging pipe 341, the liquid discharging pipe 341 is connected to the water inlet pipe 31 or the water outlet pipe 32, the collecting member 342 is provided at the liquid discharging pipe 341, the collecting member 342 is in communication with the liquid discharging pipe 341, and the collecting member 342 is located on the same one side as the connecting joint 33, after the server 300 and/or the exchange 400 have/has been placed into the cabinet body 10, the server 300 and/or the exchange 400 are/is connected to the connecting joint 33 of the manifold 30, so that the manifold 30 performs heat dissipation to the server 300 and/or the exchange 400. In that process, once the server 300 and/or the exchange 400 drip/drips liquid, the liquid drips into the collecting member 342, and the collecting member 342 can direct the liquid into the liquid discharging pipe 341, whereby the liquid discharging pipe 341 discharges the liquid, to prevent the problem that the liquid in the cabinet body 10 affects the safety of the components in the cabinet body 10. In other words, by providing the leaked-liquid collecting component 34 at the manifold 30, after the server 300 and/or the exchange 400 have/has been placed into the cabinet body 10, the safety of the components in the cabinet body 10 may be increased, to prevent the components from being affected by the liquid.

It should be noted that the quantity of the collecting member 342 may be configured according to practical demands, and the quantity of the collecting member 342 is equal to the sum of the quantity of the server 300 and the quantity of the exchange 400 that the cabinet body 10 can contain, which may ensure that all of the server 300 and/or the exchange 400 in the cabinet body 10 are not affected by the liquid.

In addition, in some embodiments, a collecting disk 001 and a guiding pipe 002 may be provided at the bottom of the cabinet body 10. The liquid discharging pipe 341 has a liquid outlet opening, the liquid outlet opening faces the collecting disk 001, one end of the guiding pipe 002 is in communication with the collecting disk 001, and the other end of the guiding pipe 002 is located outside the cabinet body 10.

Because the liquid discharging pipe 341 has the liquid outlet opening, the liquid outlet opening faces the collecting disk 001, one end of the guiding pipe 002 is in communication with the collecting disk 001, and the other end of the guiding pipe 002 is located outside the cabinet body 10, once the server 300 and/or the exchange 400 have/has been placed into the cabinet body 10, after the liquid dripped from the server 300 and/or the exchange 400 has dripped into the collecting member 342, the collecting member 342 directs the liquid into the liquid discharging pipe 341, and the liquid can flow into the collecting disk 001 via a liquid discharging opening of the liquid discharging pipe 341. Subsequently, the liquid flows from the collecting disk 001 into the guiding pipe 002, and flows from the guiding pipe 002 to the exterior of the cabinet body 10, which may prevent the liquid from residing in the cabinet body 10. In other words, by providing the collecting disk 001 and the guiding pipe 002, the safety of the components in the cabinet body 10 may be further increased.

In addition, in some embodiments, the connecting joint 33 may be connected to the water outlet pipe 32 and/or the water inlet pipe 31 by a first elastic member.

Because the connecting joint 33 is connected to the water outlet pipe 32 and/or the water inlet pipe 31 by the first elastic member, when the server 300 and/or the exchange 400 are/is being placed into the cabinet body 10, once the server 300 and/or the exchange 400 have/has been connected to the connecting joint 33, the server 300 and/or the exchange 400 can apply force to the connecting joint 33, so that the connecting joint 33 applies force to the first elastic member, whereby the first elastic member applies a counter acting force to the connecting joint 33, to cause the connection between the connecting joint 33 and the server 300 and/or the exchange 400 to be closer and firmer. In other words, by connecting the connecting joint 33 to the water outlet pipe 32 and/or the water inlet pipe 31 by the first elastic member, the fastness and the tightness of the connection between the connecting joint 33 and the server 300 and/or the exchange 400 may be increased.

It should be noted that the first elastic member may be a spring. Certainly, the first elastic member may also be an elastic sheet. The particular type of the first elastic member is not limited in the embodiments of the present application.

In addition, in some embodiments, the power bus bar 20 is provided with an electric-power supplying connector, the electric-power supplying connector may be connected to the power bus bar 20 by a second elastic member, and the electric-power supplying connector is for being connected to the server 300 and/or the exchange 400, to supply electric power to the server 300 and/or the exchange 400.

Because the electric-power supplying connector is connected to the power bus bar 20 by the second elastic member, when the server 300 and/or the exchange 400 are/is being placed into the cabinet body 10, once the server 300 and/or the exchange 400 have/has been connected to the electric-power supplying connector, the server 300 and/or the exchange 400 can apply force to the electric-power supplying connector, so that the electric-power supplying connector applies force to the second elastic member, whereby the second elastic member applies a counter acting force to the electric-power supplying connector, to cause the connection between the electric-power supplying connector and the server 300 and/or the exchange 400 to be closer and firmer. In other words, by connecting the electric-power supplying connector to the water outlet pipe 32 and/or the water inlet pipe 31 by the second elastic member, the fastness and the tightness of the connection between the electric-power supplying connector and the server 300 and/or the exchange 400 may be increased.

It should be noted that the second elastic member may be a spring. Certainly, the second elastic member may also be an elastic sheet. The particular type of the second elastic member is not limited in the embodiments of the present application.

In addition, in some embodiments, each of the two side walls 101 in the first direction of the cabinet body 10 may be connected to an adapter bracket, the adapter brackets are located in the cabinet body 10, the adapter brackets are for installing a server 300 of a first size, and the side walls 101 of the cabinet body 10 are for installing a server 300 of a second size. The size of the server 300 of the first size and the size of the server 300 of the second size are unequal.

Because each of the two side walls 101 in the first direction of the cabinet body 10 may be connected to the adapter bracket, and the adapter brackets are located in the cabinet body 10, when the server 300 of the first size is being mounted into the cabinet body 10, the adapter brackets may be connected to the side walls 101 of the cabinet body 10, and subsequently the server 300 of the first size is mounted via the adapter brackets. When the server 300 of the second size is being mounted into the cabinet body 10, the adapter brackets may be detached from the cabinet body 10, and the server 300 of the second size is mounted in the cabinet body 10. In other words, by providing the adapter brackets at the side walls 101 of the cabinet body 10, the server 300 of the first size and/or the server 300 of the second size can be installed in the cabinet body 10, so that the servers 300 that can be installed in the cabinet body 10 have many types, whereby the cabinet body 10 has a more extensive application range.

It should be noted that the server 300 of the first size may be a server 300 of 19 inches, and the server 300 of the second size may be a server 300 of 21 inches. Certainly, the server 300 of the first size may also be a server 300 of another size, and the server 300 of the second size may also be a server 300 of another size.

In addition, in an embodiment of the present application, the adapter brackets may be detachably connected to the side walls 101 of the cabinet body 10. For example, the adapter brackets may be connected to the side walls 101 of the cabinet body 10 by bolts. As another example, the adapter brackets are connected to the side walls 101 of the cabinet body 10 by pins.

It should be noted that the quantity of the adapter brackets may be configured according to practical demands. For example, the quantity of the adapter brackets is 6. As another example, the quantity of the adapter brackets is 8. That is not limited in the embodiments of the present application.

In addition, in some embodiments, the cabinet body 10 may have a front opening and a rear opening, each of the adapter brackets may be connected to a first sliding rail, the first sliding rails extend in the direction from the front opening to the rear opening, and the first sliding rails are for installing the server 300 of the first size. Each of the side walls 101 of the cabinet body 10 may be provided with a second sliding rail 11, the second sliding rails 11 extend in the direction from the front opening to the rear opening, and the second sliding rails 11 are for installing the server 300 of the second size.

Because each of the adapter brackets is connected to the first sliding rail, and the first sliding rails extend in the direction from the front opening to the rear opening, after the adapter brackets have been connected to the side walls 101 of the cabinet body 10, when it is required to install the server 300 of the first size, the server 300 of the first size may be installed directly by using the first sliding rails, which facilitates to install the server 300 of the first size into the cabinet body 10. When it is required to install the server 300 of the second size, the adapter brackets may be detached, to cause all of the first sliding rails and the adapter brackets to be detached, so that the server 300 of the second size can be installed by using the second sliding rails 11, which facilitates to install the server 300 of the second size into the cabinet body 10.

In addition, in some embodiments, fixing strips 12 may be provided at both of the front opening and the rear opening of the cabinet body 10, fixing holes 121 are provided separately in each of the fixing strips 12, the fixing strips 12 extend in the direction from the top of the cabinet body 10 to the bottom of the cabinet body 10, and the fixing holes 121 are for fixing the server 300 of the first size and/or the server 300 of the second size.

Because the fixing strips 12 are provided at both of the front opening and the rear opening of the cabinet body 10, and the fixing holes 121 are provided separately in each of the fixing strips 12, after the server 300 has been placed into the cabinet body 10, the server 300 may be connected to the fixing holes 121 in the fixing strip 12 at the front opening and the fixing holes 121 in the fixing strip 12 at the rear opening, so that the server 300 is installed in the cabinet body 10 more firmly. Particularly, after the server 300 of the first size has been installed into the cabinet body 10, the server 300 of the first size may be connected to the fixing holes 121 in the fixing strips 12. After the server 300 of the second size has been installed into the cabinet body 10, the server 300 of the second size may be connected to the fixing holes 121 in the fixing strips 12. In other words, by providing the fixing strips 12 and providing the fixing holes 121 in the fixing strips 12, that may facilitate to fix the servers 300, so that the servers 300 are installed in the cabinet body 10 more stably.

It should be noted that the shapes of the fixing holes 121 may be configured according to practical demands. For example, the fixing holes 121 are square holes. As another example, the fixing holes 121 are hexagonal holes. That is not limited in the embodiments of the present application.

In addition, in an embodiment of the present application, the server 300 may be provided with clipping hooks. After the server 300 has been placed into the cabinet body 10, the clipping hooks may be clipped into the fixing holes 121.

In addition, in an embodiment of the present application, the quantity of the fixing holes 121 may be configured according to practical demands. For example, the quantity of the fixing holes 121 is 15. As another example, the quantity of the fixing holes 121 is 18. That is not limited in the embodiments of the present application.

In addition, in the first direction, both of the side walls 101 that face each other at the front opening and the rear opening of the cabinet body 10 may be connected to the fixing strips 12. Therefore, after the server 300 has been installed into the cabinet body 10, both of the two opposing sides in the first direction of the server 300 can be connected to the fixing holes 121 in the fixing strips 12, to further improve the stability of the installation of the server 300.

In addition, in some embodiments, the cabinet body 10 may have a front opening and a rear opening, each of the two side walls 101 that face each other in the first direction of the cabinet body 10 is connected to a third sliding rail 13, and the third sliding rails 13 are for installing an exchange 400.

Because each of the two side walls 101 that face each other in the first direction of the cabinet body 10 is connected to the third sliding rail 13, when it is required to install the exchange 400 into the cabinet body 10, the exchange 400 can be directly installed into the cabinet body 10 by using the third sliding rails 13. In other words, by providing the third sliding rails 13, that may facilitate the installation of the exchange 400 in the cabinet body 10.

In addition, in some embodiments, the cabinet body 10 may have a front opening and a rear opening, each of the two side walls 101 that face each other in the first direction of the cabinet body 10 is connected to a fourth sliding rail 14, and the fourth sliding rails 14 are for installing a power-supply frame 500.

Because each of the two side walls 101 that face each other in the first direction of the cabinet body 10 is connected to the fourth sliding rail 14, when it is required to install the power-supply frame 500 into the cabinet body 10, the power-supply frame 500 can be directly installed into the cabinet body 10 by using the fourth sliding rails 14. In other words, by providing the fourth sliding rails 14, that may facilitate the installation of the power-supply frame 500 in the cabinet body 10.

It should be noted that an electric-power supplying device may be provided in the power-supply frame 500, and the electric-power supplying device may be electrically connected to the power bus bar 20.

In addition, in an embodiment of the present application, universal wheels may be provided at the bottom of the cabinet body 10, so as to facilitate to move the cabinet body 10. The quantity of the universal wheels may be configured according to practical demands. For example, the quantity of the universal wheels is 4. As another example, the quantity of the universal wheels is 8. That is not limited in the embodiments of the present application.

In the embodiments of the present application, because both of the power bus bar 20 and the manifold 30 are provided in the cabinet body 10, the crossbeam 40 is provided in the cabinet body 10, the cabinet body 10 has two side walls 101 that face each other in the first direction, the two ends of the crossbeam 40 are fixedly connected to the two side walls 101, and both of the power bus bar 20 and the manifold 30 are fixed to the crossbeam 40, when the server 300 is being installed into the cabinet body 10, one may apply force directly to the server 300, so that, once the server 300 has entered the cabinet body 10, the server 300 can be connected to the power bus bar 20 and the manifold 30 simultaneously, to realize blind-mate insertion of the server 300. Furthermore, the power bus bar 20 and the manifold 30 are fixed to the crossbeam 40, whereby, when one is applying force to the server 300, to cause the server 300 to be installed into the cabinet body 10, the server 300 can apply force to the power bus bar 20 and the manifold 30, and the power bus bar 20 and the manifold 30 can transfer the force to the crossbeam 40, which means that the crossbeam 40 can serve to support the power bus bar 20 and the manifold 30. In other words, in the embodiments of the present application, by providing the crossbeam 40 in the cabinet body 10 and configuring that both of the manifold 30 and the power bus bar 20 are fixed to the crossbeam 40, in the installation of the server 300 into the cabinet body 10, the server 300 can be directly pushed into the cabinet body 10, so that the server 300 can be connected to the power bus bar and the manifold 30 simultaneously. That prevents the problem that, in the installation of the server 300, the operator manually connects the server 300 and the manifold 30, which results in a low efficiency of the installation. In other words, the server cabinet according to the embodiments of the present application may increase the efficiency of the installation of the server 300 into the cabinet body 10, and may realize blind-mate insertion of the server 300.

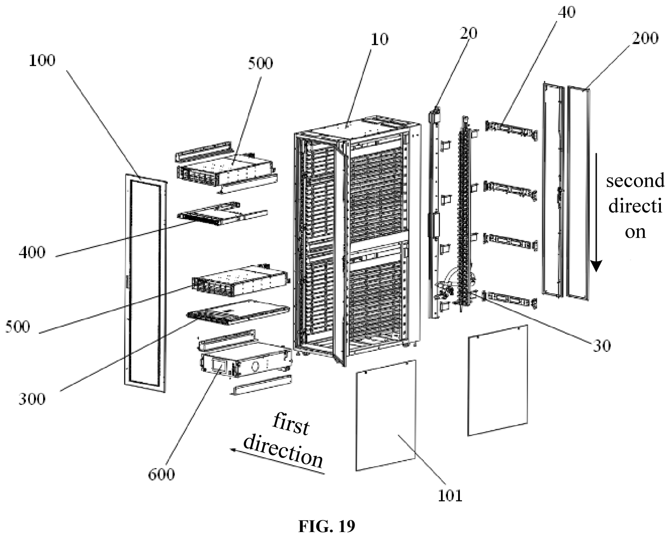

An embodiment of the present application provides a complete-cabinet system. As shown in FIG. 19, the complete-cabinet system comprises a server 300 and the server cabinet according to any one of the above embodiments. The server 300 is installed in the cabinet body 10, and the server 300 is connected to the power bus bar 20 and the manifold 30.

In the embodiments of the present application, because both of the power bus bar 20 and the manifold 30 are provided in the cabinet body 10, the crossbeam 40 is provided in the cabinet body 10, the cabinet body 10 has two side walls 101 that face each other in the first direction, the two ends of the crossbeam 40 are fixedly connected to the two side walls 101, and both of the power bus bar 20 and the manifold 30 are fixed to the crossbeam 40, when the server 300 is being installed into the cabinet body 10, one may apply force directly to the server 300, so that, once the server 300 has entered the cabinet body 10, the server 300 can be connected to the power bus bar 20 and the manifold 30 simultaneously, to realize blind-mate insertion of the server 300. Furthermore, the power bus bar 20 and the manifold 30 are fixed to the crossbeam 40, whereby, when one is applying force to the server 300, to cause the server 300 to be installed into the cabinet body 10, the server 300 can apply force to the power bus bar 20 and the manifold 30, and the power bus bar 20 and the manifold 30 can transfer the force to the crossbeam 40, which means that the crossbeam 40 can serve to support the power bus bar 20 and the manifold 30. In other words, in the embodiments of the present application, by providing the crossbeam 40 in the cabinet body 10 and configuring that both of the manifold 30 and the power bus bar 20 are fixed to the crossbeam 40, in the installation of the server 300 into the cabinet body 10, the server 300 can be directly pushed into the cabinet body 10, so that the server 300 can be connected to the power bus bar and the manifold 30 simultaneously. That prevents the problem that, in the installation of the server 300, the operator manually connects the server 300 and the manifold 30, which results in a low efficiency of the installation. In other words, the server cabinet according to the embodiments of the present application may increase the efficiency of the installation of the server 300 into the cabinet body 10, and may realize blind-mate insertion of the server 300, so that the assembling of the complete-cabinet system has an increased assembling efficiency.

In addition, in some embodiments, a third sliding rail 13 and a fourth sliding rail 14 may be provided in the cabinet body 10, the complete-cabinet system further comprises an exchange 400 and a power-supply frame 500, and an electric-power supplying device is provided in the power-supply frame 500. The exchange 400 is installed in the cabinet body 10 via the third sliding rail 13, and the power-supply frame 500 is installed in the cabinet body 10 via the fourth sliding rail 14.

By providing the third sliding rails 13 and the fourth sliding rails 14 in the cabinet body 10, the exchange 400 can be directly installed into the cabinet body 10 by using the third sliding rails 13, and the power-supply frame 500 can be directly installed into the cabinet body 10 by using the fourth sliding rails 14. In addition, the electric-power supplying device in the power-supply frame 500 may be electrically connected to the power bus bar 20 in the cabinet body 10.

In addition, in an embodiment of the present application, the server 300 may be provided with a cooling connector and an electricity-charging connector. Both of the cooling connector and the electricity-charging connector may be connected to the server 300 by third elastic members. Therefore, after the server 300 has been placed into the cabinet body 10, the cooling connector may be connected to the electric-power supplying connector of the power bus bar 20, and the cooling connector may be connected to the connecting joint 33 of the manifold 30, whereby the connecting joint 33 and the cooling connector generate a pressure therebetween. The pressure can be transferred to the cooling connector, the cooling connector transfers the force to the third elastic member, and the third elastic member generates a counter acting force to the cooling connector, whereby the connection between the cooling connector and the connecting joint 33 is closer and firmer. Likewise, the electric-power supplying connector is connected to the electricity-charging connector, the electric-power supplying connector and the electricity-charging connector can generate a pressure therebetween, the electricity-charging connector transfers the pressure to the third elastic member, and the third elastic member generates a counter acting force to the electricity-charging connector, whereby the connection between the electricity-charging connector and the electric-power supplying connector is closer and firmer.

In addition, in an embodiment of the present application, the complete-cabinet system may further comprise a cooling-liquid distributing device 600, the cooling-liquid distributing device 600 is connected to the manifold 30, and the cooling-liquid distributing device 600 is for circulating the cooling water in the manifold 30.

In the description of the present application, the description referring to the terms "an embodiment", "some embodiments", "illustrative embodiment", "example", "particular example" or "some examples" and so on means that particular features, structures, materials or characteristics described with reference to the embodiment or example are comprised in at least one of the embodiments or examples of the present application. In the description, the illustrative expressions of the above terms do not necessarily refer to the same embodiment or example. Furthermore, the described particular features, structures, materials or characteristics may be combined in any one or more embodiments or examples in a suitable form.

Although the embodiments of the present application have already been illustrated and described, a person skilled in the art can understand that those embodiments may have various alterations, modifications, substitutions and variations without departing from the principle and the spirit of the present application, and the scope of the present application is defined by the claims and the equivalents thereof.

## Claims

1. A server cabinet, wherein the server cabinet comprises a cabinet body, a power bus bar and a manifold; and
the cabinet body has a first direction, both of the power bus bar and the manifold are provided in the cabinet body, a crossbeam is provided in the cabinet body, the cabinet body has two side walls that face each other in the first direction, two ends of the crossbeam are fixedly connected to the two side walls, and both of the power bus bar and the manifold are fixed to the crossbeam, to enable a server to be inserted perpendicularly and in a blind-mate manner to the power bus bar and the manifold.

2. The server cabinet according to claim 1, wherein the crossbeam comprises a first mounting member, a connecting beam and a second mounting member;
the first mounting member and the second mounting member are detachably connected to two opposite ends of the connecting beam, the first mounting member is connected to one of the side walls in the first direction of the cabinet body, and the second mounting member is connected to the other of the side walls in the first direction of the cabinet body; and
both of the power bus bar and the manifold are fixed to the connecting beam.

3. The server cabinet according to claim 2, wherein a plurality of mounting holes are provided separately in the connecting beam in the first direction, and the power bus bar and the manifold are connected to different instances of the mounting holes.

4. The server cabinet according to claim 3, wherein each of the power bus bar and the manifold is closer than the other to one of the two side walls that face each other in the first direction of the cabinet body.

5. The server cabinet according to claim 3, wherein the crossbeam further comprises a first connector, the first connector is detachably connected to the mounting holes, and the power bus bar is connected to the first connector, to enable the server to be inserted perpendicularly and in a blind-mate manner to the power bus bar.

6. The server cabinet according to claim 3, wherein the crossbeam further comprises a second connector, the second connector is detachably connected to the mounting holes, and the manifold is connected to the second connector, to enable the server to be inserted perpendicularly and in a blind-mate manner to the manifold.

7. The server cabinet according to claim 2, wherein the connecting beam is provided with at least one through hole; and
after the server has been installed into the cabinet body, the through hole faces the server, and the through hole ventilates for the server.

8. The server cabinet according to claim 1, wherein the cabinet body further has a second direction intersecting with the first direction, the cabinet body has a top and a bottom that face each other in the second direction, and two opposite ends of the power bus bar are connected to the top and the bottom of the cabinet body.

9. The server cabinet according to claim 1, wherein the cabinet body has a front opening and a rear opening that face each other, a first hinge is provided at a side wall at the front opening, and the first hinge is connected to a front door;
in response to the front door being in a closing state, the front door blocks the front opening, and the front door is flush with an outer surface of the cabinet body; and
in response to the front door being in an opening state, the front door releases the blocking to the front opening, and the front door has a first included angle with the side walls of the cabinet body.

10. The server cabinet according to claim 9, wherein a second hinge is provided at a side wall at the rear opening, and the second hinge is connected to a rear door;
in response to the rear door being in a closing state, the rear door blocks the rear opening, and the rear door is flush with the outer surface of the cabinet body; and
in response to the rear door being in an opening state, the rear door releases the blocking to the rear opening, and the rear door has a second included angle with the side walls of the cabinet body.

11. The server cabinet according to claim 10, wherein both of the front door and the rear door are provided with a ventilation hole.

12. The server cabinet according to claim 1, wherein the manifold comprises a water inlet pipe, a water outlet pipe and a connecting joint; and
the water inlet pipe and the water outlet pipe are arranged side by side, the water inlet pipe and/or the water outlet pipe are/is connected to the connecting joint, the water inlet pipe is for cooling water to flow in, the water outlet pipe is for cooling water to flow out, and the connecting joint is for connecting the server and/or an exchange.

13. The server cabinet according to claim 12, wherein the manifold is provided with a leaked-liquid collecting component, the leaked-liquid collecting component comprises a liquid discharging pipe, the liquid discharging pipe is connected to the water inlet pipe or the water outlet pipe, a collecting member is provided at the liquid discharging pipe, the collecting member is in communication with the liquid discharging pipe, the collecting member is located on a same one side as the connecting joint, the collecting member is for, when the connecting joint is connected to the server and/or the exchange, collecting liquid dripped from the server and/or the exchange, and directing the liquid into the liquid discharging pipe, and the liquid discharging pipe is for discharging the liquid.

14. The server cabinet according to claim 13, wherein a collecting disk and a guiding pipe are provided at a bottom of the cabinet body; and
the liquid discharging pipe has a liquid outlet opening, the liquid outlet opening faces the collecting disk, one end of the guiding pipe is in communication with the collecting disk, and the other end of the guiding pipe is located outside the cabinet body.

15. The server cabinet according to claim 12, wherein the connecting joint is connected to the water outlet pipe and/or the water inlet pipe by a first elastic member.

16. The server cabinet according to claim 1, wherein the power bus bar is provided with an electric-power supplying connector, the electric-power supplying connector is connected to the power bus bar by a second elastic member, and the electric-power supplying connector is for being connected to the server and/or an exchange, to supply electric power to the server and/or the exchange.

17. The server cabinet according to claim 1, wherein each of the two side walls in the first direction of the cabinet body is connected to an adapter bracket, the adapter brackets are located in the cabinet body, the adapter brackets are for installing a server of a first size, and the side walls of the cabinet body are for installing a server of a second size;
wherein the size of the server of the first size and the size of the server of the second size are unequal.

18. The server cabinet according to claim 17, wherein the cabinet body has a front opening and a rear opening, each of the adapter brackets is connected to a first sliding rail, the first sliding rails extend in a direction from the front opening to the rear opening, and the first sliding rails are for installing the server of the first size; and
each of the side walls of the cabinet body is provided with a second sliding rail, the second sliding rails extend in the direction from the front opening to the rear opening, and the second sliding rails are for installing the server of the second size.

19. The server cabinet according to claim 18, wherein fixing strips are provided at both of the front opening and the rear opening of the cabinet body, fixing holes are provided separately in each of the fixing strips, the fixing strips extend in a direction from a top of the cabinet body to a bottom of the cabinet body, and the fixing holes are for fixing the server of the first size and/or the server of the second size.

20. The server cabinet according to claim 1, wherein the cabinet body has a front opening and a rear opening, each of the two side walls that face each other in the first direction of the cabinet body is connected to a third sliding rail, and the third sliding rails are for installing an exchange.

21. The server cabinet according to claim 1, wherein the cabinet body has a front opening and a rear opening, each of the two side walls that face each other in the first direction of the cabinet body is connected to a fourth sliding rail, and the fourth sliding rails are for installing a power-supply frame.

22. A complete-cabinet system, wherein the complete-cabinet system comprises a server and the server cabinet according to any one of claims 1-21; and
the server is installed in the cabinet body, and the server is connected to the power bus bar and the manifold.

23. The complete-cabinet system according to claim 22, wherein a third sliding rail and a fourth sliding rail are provided in the cabinet body, the complete-cabinet system further comprises an exchange and a power-supply frame, and an electric-power supplying device is provided in the power-supply frame; and
the exchange is installed in the cabinet body via the third sliding rail, and the power-supply frame is installed in the cabinet body via the fourth sliding rail.
